(19) Europäisches Patentamt / European Patent Office / Office européen des brevets

(11) **EP 2 124 347 A2**

(12) **EUROPEAN PATENT APPLICATION**

(43) Date of publication:
    **25.11.2009 Bulletin 2009/48**

(51) Int Cl.:
    *H04B 1/04* [(2006.01)]     *H03G 3/20* [(2006.01)]

(21) Application number: **08172645.7**

(22) Date of filing: **22.12.2008**

(84) Designated Contracting States:
    **AT BE BG CH CY CZ DE DK EE ES FI FR GB GR HR HU IE IS IT LI LT LU LV MC MT NL NO PL PT RO SE SI SK TR**
    Designated Extension States:
    **AL BA MK RS**

(30) Priority: **20.05.2008 JP 2008131592**

(71) Applicant: **Fujitsu Limited**
    **Kawasaki-shi, Kanagawa 211-8588 (JP)**

(72) Inventors:
    • **Suzuki, Kenji**
      **c/o Fujitsu Limited**
      **Kawasaki-shi, Kanagawa 211-8588 (JP)**

    • **Satou, Michiko**
      **c/o Fujitsu Limited**
      **Kawasaki-shi, Kanagawa 211-8588 (JP)**
    • **Tsuchiya, Toshikazu**
      **c/o Fujitsu Limited**
      **Kawasaki-shi, Kanagawa 211-8588 (JP)**

(74) Representative: **Stebbing, Timothy Charles**
    **Haseltine Lake LLP**
    **Lincoln House, 5th Floor**
    **300 High Holborn**
    **London WC1V 7JH (GB)**

(54) **Radio transmission apparatus**

(57)    A radio transmission apparatus performs peak suppression processing in the two stages of pre-peak suppression processing and post-peak suppression processing. The gain adjustment processing of transmission power is performed in the two stages of coarse gain adjustment processing (20), prior to the pre-peak suppression processing (31), and fine gain adjustment processing (34) prior to the post-peak suppression processing (33). The fine gain adjustment processing (34) has a smaller adjustment step width than the coarse gain adjustment processing (20), and can adjust the transmission power in response to a small variation of the transmission power. In the pre-peak suppression processing (31), a peak suppression value corresponding to the gain set by the coarse gain adjustment processing (20) is set on the basis of each value being preset in a table for each transmission power value. In the post-peak suppression processing (33), the peak suppression value corresponding to the gain modified by the fine gain adjustment processing (34) is obtained by calculation.

FIG. 2

EP 2 124 347 A2

**Description**

The present invention relates to a radio transmission apparatus performing peak suppression processing of a transmission signal having a peak component, and more particularly a radio transmission apparatus improving adjustment accuracy of a gain and a peak suppression value of a transmission signal in response to the variation of transmission power.

A multicarrier transmission system transmits data by dividing into a plurality of subcarriers in parallel. Because the symbol period can be elongated as compared to a single carrier transmission, deteriorated transmission due to multipath can be reduced. Further, in OFDM (Orthogonal Frequency Division Multiplexing), which is an effective means to achieve multicarrier transmission, high frequency use efficiency and high-speed transmission can be achieved because of signal transmission on a plurality of orthogonal subcarriers.

The multicarrier transmission system (OFDM in particular) has been put into practical use in terrestrial digital broadcasting, wireless LANs, etc. In recent years, the application to WiMAX (Worldwide Interoperability for Microwave Access), which is a standard of mobile communication such as mobile telephones and high-speed wireless data communication, has been in progress. WiMAX (including mobile WiMAX) is standardized by IEEE 802.16-2004/IEEE802.16e. Hereafter, an example of a radio transmission apparatus in which OFDM is employed as transmission system will be described.

The radio transmission apparatus generates and transmits an OFDM modulation signal, in which mutually orthogonal subcarrier signals are processed by inverse Fast Fourier Transform (IFFT), to frequency multiplex each subcarrier signal. The OFDM modulation signal generated by the IFFT processing includes a peak component, and PAPR (Peak-to-Average Power Ratio) becomes larger. In other words, as compared to average transmission power, peak transmission power tends to be remarkably large. When a signal having a large PAPR is to transmit, in a transmission power amplifier (hereafter simply referred to as "amplifier") mounted on the radio transmission apparatus, high linearity is required over a wide dynamic range to prevent nonlinear distortion of the transmission signal in signal amplification, as well as power leakage to an adjacent channel.

In general, the linearity and the efficiency of the amplifier are characteristics which are contrary to each other. When securing high linearity over a wide dynamic range, power efficiency decreases, and power consumption increases in the radio transmission apparatus. Therefore, in order to limit PAPR, peak suppression processing to suppress peak transmission power has been enforced. In the above peak suppression processing, there is a known method of executing in two stages : pre-peak suppression processing by a hard clipping method, and post-peak suppression processing by a window function method (Patent document 1). The peak suppression processing is also effective to improve an adjacent channel leakage power characteristic, ACLR (Adjacent Channel Leakage Ratio). By setting a peak suppression value according to transmission power, a good ACLR characteristic can be obtained.

Further, in addition to the intention to improve the power efficiency, distortion compensation processing is enforced to suppress nonlinear distortion by linealizing the amplification characteristic of the amplifier. As one of the disposition compensation processing, a digital pre-distortion system is known. The principle of the digital pre-distortion system is that a characteristic inverse to an amplifier distortion characteristic is added in advance to an amplifier input signal, so as to obtain a desired signal having no distortion in the amplifier output. By comparing a transmission signal before distortion compensation with a demodulated feedback signal, and using the error therebetween, a distortion compensation coefficient is calculated and updated. The distortion compensation coefficient is stored into a memory using transmission signal amplitude, power, or the function thereof, as a memory address. Then, using the updated distortion compensation coefficient, digital pre-distortion processing is performed on a transmission signal to be transmitted next, and the pre-distortion processed signal is output. By repeating the above operation, finally, a convergence to an optimal distortion compensation coefficient is made, and thereby the amplifier distortion is compensated.

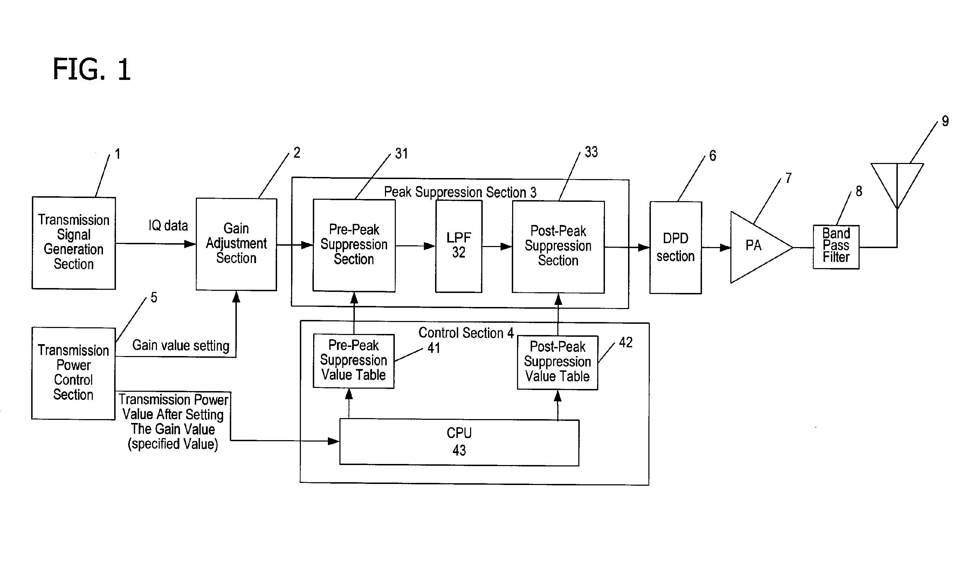

FIG. 1 is a diagram illustrating the conventional configuration of peak suppression processing in a radio transmission apparatus. A transmission signal generation section 1 generates and outputs a digital data string of transmission signals . A gain adj ustment section 2 is a means for adjusting, at the stage of the digital data prior to amplification, a transmission signal gain to absorb variation of actual transmission power, radiated from an antenna, caused by performance dispersion of analog circuit components etc. in the radio transmission apparatus. A gain coefficient being set into gain adjustment section 2 is preset by a transmission power control section 5. Transmission power control section 5 sets the gain coefficient to form the transmission power to be a specified value.

A pre-peak suppression section 31 in a peak suppression section 3 executes peak suppression processing by the hard clipping method so as to cut a signal portion exceeding a predetermined threshold. Because out-of-band radiation is produced when performing the peak suppression processing by the hard clipping method, band limitation processing is performed by a low pass filter (LPF) 32.

Next, in order to suppress the peak after the band limitation processing with as small signal deterioration as possible, a post-peak suppression section 33 executes peak suppression processing by the window function method. The peak suppression processing using a window function decreases a peak point to a suppression level by multiplying such a correction coefficient as to produce the peak point exceeding the threshold of the suppression level to be [suppression level/ peak value of an input signal envelope]. At that time, to prevent the occurrence of discontinuity at the peak point, the window function is used as a coefficient for correction. The height (the level at the highest portion) of the window function is [suppression level/ peak value of the input signal envelope], and the magnitudes between the start point and the end point are one-fold. By multiplication with the timing of the highest portion of the window function to be coincident with the peak point, the peak point can be reduced to the suppression level (threshold) with smooth and continuous variation before and after the peak point.

A DPD section 6 executes distortion compensation processing using the aforementioned digital pre-distortion system. After the peak suppression processing and the distortion compensation processing, the transmission signal is amplified by an amplifier (PA) 7, and transmitted from an antenna 9 through a band pass filter 8.

A control section 4 controls the peak suppression value in pre-peak suppression section 31 and post-peak suppression section 33 according to the transmission power. Specifically, control section 4 includes a pre-peak suppression value table 41 having peak suppression values corresponding to transmission power values, to be set to pre-peak suppression section 31, and a post-peak suppression value table 42 having peak suppression values corresponding to the transmission power values, to be set to post-peak suppression section 33. Control section 4 also includes a CPU 43 for selecting thresholds from tables 41, 42 according to the transmission power being set by a transmission power control section 5, and for setting the selected thresholds into pre-peak suppression section 31 and post-peak suppression section 33.

The reason why the peak suppression value is varied according to the transmission power is as follows: in order to make constant the actual transmission power from an antenna end, if the transmission power of a transmission signal (digital data) is adjusted in the prior stage of the peak suppression processing, it is known that the PAPR characteristic varies, causing deterioration of both modulation accuracy (hereafter referred to as EVM, Error Vector Magnitude) and the ACLR.

Therefore, when adjusting the transmission power by gain adjustment section 2, in order to avoid the occurrence of deteriorated EVM, it is necessary to vary the peak suppression value according to the transmission power. Thus, there are provided tables 41, 42 for storing peak suppression values (thresholds) according to the transmission power values. Conventionally, in an evaluation work on an apparatus-by-apparatus basis before shipment from the factory, tables 41, 42 have been generated using the peak suppression values corresponding to the transmission power values, individually obtained on an apparatus-by-apparatus basis. In the evaluation work, each peak suppression value to make CCDF (Complementary Cumulative Distribution Function) to be constant corresponding to each transmission power value is obtained. The CCDF is a statistic method for interpreting a signal PAPR characteristic, and by measuring the PAPR characteristic and the CCDF, it is possible to confirm whether adjacent channel leakage power is in an appropriate range.

If the transmission power is increased with a fixed peak suppression value, CCDF is reduced and suppression effect is increased, causing the deterioration of EVM. Also, if the transmission power is decreased with a fixed peak suppression value, CCDF is increased and the suppression effect is decreased, causing the deterioration of ACLR. As such, with the variation of CCDF, the radio transmission characteristics such as EVM, ACLR are deteriorated. Therefore, in response to varied transmission power, by appropriately setting the peak suppression value to make CCDF constant, the deterioration of the radio transmission characteristics such as EVM and ACLR has been prevented.

[Patent document 1] the Japanese Unexamined Patent Publication No. 2007-194825.

However, transmission power having been adjusted at the evaluation stage before shipment from a factory varies. Typically, there are differences depending on the dispersion of analog components in a radio transmission apparatus, an environment in which the radio transmission apparatus is actually installed, and the installation location. With a variety of conditions such as the temperature at the installation location and a passing loss due to a signal line length to the antenna, actual transmission power becomes different from the transmission power at the time of evaluation before shipment from the factory.

Further, in WiMAX communication using OFDM, the modulation scheme varies during operation, and the transmission power also varies depending on the modulation scheme.

As such, in response to the variation of the transmission power, it is necessary to adjust the transmission power by varying the transmission power gain by means of gain adjustment section 2. Therefore, in the evaluation work before shipment from the factory, peak suppression values to make CCDF constant are fully obtained for a plurality of transmission power values, which are set in tables 41, 42. However, the work to obtain the peak suppression value corresponding to one transmission power value is complicated and takes a long time, because a balance must be taken between the peak suppression values in pre-peak suppression section 31 and post-peak suppression section 33. As a result, the peak suppression values to be obtained correspondingly to the transmission power values in the range of adjustment are compelled to have a relatively coarse unit of variation (adjustment step width) with a step of 1 dB, for example. Therefore, it has not been possible to set an appropriate peak suppression value to a unit of variation of the transmission power (with a step of 0.1 dB, for example), smaller than a step of 1 dB.

The smaller the adjustment step width of the transmission power is set, the more enormous the work to obtain the peak suppression values becomes. It is not realistic to obtain peak suppression values with a small unit of variation (adjustment step width) by consuming an enormous time and labor, and it is not possible to control the peak suppression value in response to each small transmission power variations of transmission signals with high accuracy. Further, a table size corresponding to the adjustment steps is required.

Moreover, conventionally, to suppress transmission power variation, expensive components having small dispersion have been used, which lead to high apparatus cost.

Accordingly, it is desirable to provide a radio transmission apparatus capable of setting an optimal peak suppression value to a transmission signal, having varied transmission power, with high accuracy without deteriorating a radio transmission characteristic.

According to one aspect of the invention, a radio transmission apparatus generating a transmission signal including a peak component, so as to transmit from an antenna, includes: a first gain adjustment section performing gain adjustment by multiplying the transmission signal by a first gain coefficient; a first peak suppression section suppressing the peak component of the transmission signal being output from the first gain adjustment section, according to a first peak suppression value; a low pass filter filtering the transmission signal being output from the first peak suppression section; a second gain adjustment section performing gain adjustment by multiplying the transmission signal being output from the low pass filter by a second gain coefficient; a second peak suppression section suppressing the peak component of the transmission signal being output from the second gain adjustment section, according to a second peak suppression value; and a control section calculating the second gain coefficient and the second peak suppression value based on a variation ratio between transmission signal power being output from the first gain adjustment section and transmission signal power in a posterior stage to the second peak suppression section.

The radio transmission apparatus executes two stages of peak suppression processing, and executes gain adjustment processing immediately before each stage of the peak suppression processing. Further, there are obtained by calculation a gain coefficient of the gain adjustment processing in the posterior stage (processing in a second gain adjustment section) and a peak suppression value of the peak suppression processing in the posterior stage (processing in a second peak suppression section), according to the variation ratio of the transmission power.

When a first peak suppression value is given in advance to each of a plurality of transmission power values in a unit of a first step, and when a first peak suppression value corresponding to a transmission power value according to the first gain coefficient is set, there are obtained by calculation a second gain coefficient and a second peak suppression value corresponding to the transmission power values in a unit of a second step smaller than the first step, according to the variation ratio of the transmission power. By this, without preparation of a table having the first peak suppression values and the second peak suppression values in a smaller unit of the second step, the second gain coefficient and the second peak suppression value are modified after being obtained by calculation, while maintaining the table of the first peak suppression values in a coarse unit of the first step. Thus, it becomes possible to adjust the peak suppression value in response to the variation of the transmission power in the unit of the second step, while maintaining balance between a peak suppression amount in the first peak suppression section and a peak suppression amount in the second peak suppression section.

Other aspects of the invention provide a method of generating a transmission signal as well as a program (which may be stored on a medium) for performing the method.

According to the present invention, the radio transmission apparatus enables fine adjustment of the gain coefficient and the peak suppression value in response to the variation of transmission power. The gain coefficient and the peak suppression value can be set with high accuracy, without deteriorating the radio transmission characteristic.

Reference is made, by way of example only, to the accompanying drawings in which:

FIG. 1 is a diagram illustrating the conventional configuration of peak suppression processing in a radio transmission apparatus;

FIG. 2 is a diagram illustrating a first exemplary configuration of the radio transmission apparatus according to the present embodiment;

FIG. 3 is a processing flowchart of the gain coefficient adjustment processing in fine gain adjustment section 34 and the post-peak suppression value adjustment processing in post-peak suppression section 33 executed by the radio transmission apparatus having the first exemplary configuration;

FIG. 4 is a diagram illustrating a second exemplary configuration of the radio transmission apparatus according to the present embodiment; and

FIG. 5 is a processing flowchart of the gain coefficient adjustment processing in fine gain adjustment section 34 and the post-peak suppression value adjustment processing in post-peak suppression section 33, in the radio transmission apparatus having the second exemplary configuration.

Embodiments of the present invention will now be described with reference to the drawings. The embodiments are for assisting the understanding of the present invention, and not for limiting the application of the present invention to these embodiments.

The radio transmission apparatus according to the present embodiment is apparatus performing peak suppression processing in the two stages of pre-peak suppression processing and post-peak suppression processing. Also, the gain adjustment processing of transmission power is performed in the two stages of coarse gain adjustment processing, prior to the pre-peak suppression processing, and fine gain adjustment processing prior to the post-peak suppression processing. The fine gain adjustment processing has a smaller adjustment step width than the coarse gain adjustment processing, and can adjust the transmission power in response to a small variation of the transmission power. Further, in the pre-peak suppression processing, a peak suppression value corresponding to the gain set by the coarse gain adjustment processing (the transmission power having an adjusted gain) is set on the basis of each value being preset in a table for each transmission power value. In contrast, in the post-peak suppression processing, the peak suppression value corresponding to the gain modified by the fine gain adjustment processing is obtained by calculation.

In the post-peak suppression processing, it is necessary to modify the peak suppression value in response to a small variation of the transmission power. By obtaining the peak suppression value by calculation, the acquisition of the peak suppression value in advance in the evaluation work beforehand and the storage thereof into the table become unnecessary.

Additionally, the coarse gain adjustment processing has the gain adjustment step width broader than the fine gain adjustment processing. Therefore, with regard to the peak suppression value for the pre-peak suppression processing, it is possible to obtain and store peak suppression values, having a relatively broad adjustment step width, into the table, as conventionally in the evaluation work beforehand. However, by preparing the variation portion of the transmission power, caused by the dispersion of components and the dispersion in the signal line length to an antenna, as an adjustment range of the fine gain adjustment processing, the preparation of the pre-peak suppression value in advance by the table becomes unnecessary.

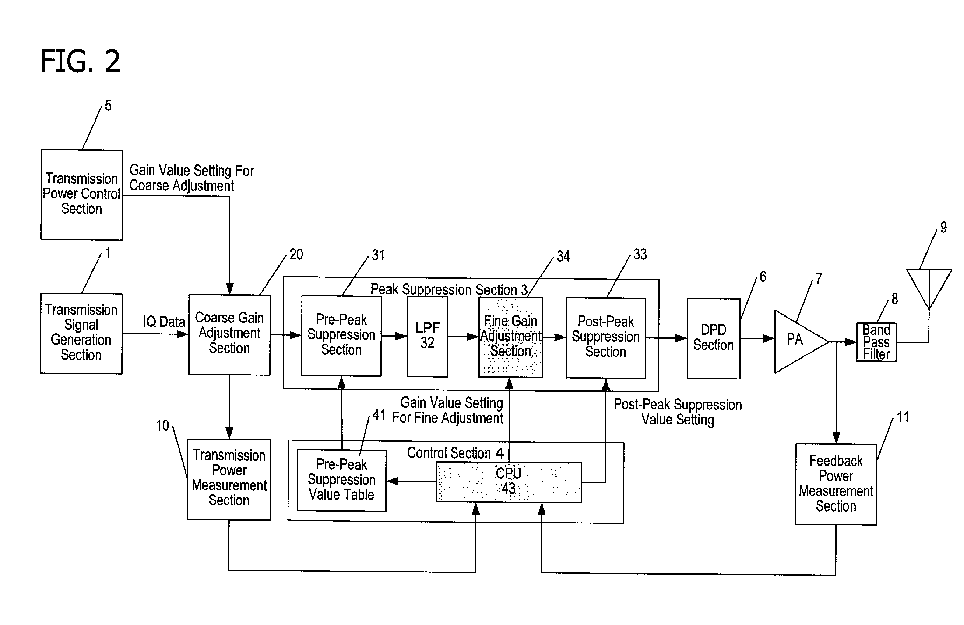

FIG. 2 is a diagram illustrating a first exemplary configuration of the radio transmission apparatus according to the present embodiment. A transmission signal generation section 1 generates and outputs a digital data string, a transmission signal. A coarse gain adjustment section 20 is a means for adjusting the transmission signal gain before the pre-peak suppression processing, and virtually has an identical function to gain adjustment section 2 shown in FIG. 1. A gain coefficient set to coarse gain adjustment section 20 is preset by a transmission power control section 5. Transmission power control section 5 sets the gain coefficient so that the transmission power becomes a predetermined value.

The transmission signal gain adjusted by coarse gain adjustment section 20 is input into a pre-peak suppression section 31 in a peak suppression section 3. Peak suppression section 3 includes pre-peak suppression section 31 for executing peak suppression processing by the hard clipping method, and a post-peak suppression section 33 for executing peak suppression processing by the window function method. Thus, the peak suppression processing is executed in two stages.

The transmission signal whose signal portion exceeding a predetermined threshold is cut by pre-peak suppression section 31 is filtered through a low pass filter (LPF) 32, and then input into fine gain adjustment section 34. After being gain adjusted again, the above transmission signal is input into a post-peak suppression section 33. The peak suppression value to be set to pre-peak suppression section 31 (i.e. pre-peak suppression value) and the peak suppression value to be set to post-peak suppression section 33 (i.e. post-peak suppression value) are controlled by a control section 4.

Control section 4 has a pre-peak suppression set table 41 storing each pre-peak suppression value for each transmission power value to be set to pre-peak suppression section 31. According to the gain coefficient being set to coarse gain adjustment section 20 by transmission power control section 5, a CPU 43 in control section 4 selects a pre-peak suppression value from table 41, so as to set to pre-peak suppression section 31.

Also, as will be described in detail, CPU 43 compares the transmission power of the transmission signal, being output from coarse gain adjustment section 20, with the transmission power of a transmission signal being output from amplifier (PA). Then, based on the difference therebetween, CPU 43 adjusts the gain coefficient to be set to fine gain adjustment section 34, and also obtains by calculation a post-peak suppression value to be set to post-peak suppression section 33 corresponding to the gain coefficient in fine gain adjustment section 34.

A transmission power measurement section 10 measures the transmission power of the transmission signal being output from coarse gain adjustment section 20, and a feedback power measurement section 11 measures the transmission power of the transmission signal being output from amplifier (PA) 7. Both of the above measured transmission power are sent to CPU 43.

A DPD section 6 executes distortion compensation processing to the transmission signal being output from post-peak suppression section 33 by means of the digital pre-distortion system. The transmission signal, to which the peak suppression and the distortion compensation have been processed, is amplified by amplifier (PA) 7. After passing through a band pass filter 8, the transmission signal is transmitted from an antenna 9.

Hereafter, gain adjustment processing and peak suppression value adjustment processing in the radio transmission apparatus according to the present embodiment will be described.

In the evaluation work before shipment from the factory, as preparation processing, in regard to one particular transmission power (reference transmission power) value, a pre-peak suppression value to be set to pre-peak suppression section 31 and a post-peak suppression value to be set to post-peak suppression section 33 are obtained for each transmission mode (types of transmission frequency bandwidth, for example, 10 MHz × 1 wave, 10 MHz × 2 waves, etc.), and stored into an internal memory means. The above preparation processing is performed by an operator.

While the transmission power itself of the transmission signal being output from transmission signal generation section 1 differs depending on the transmission mode, the output is made from the antenna end with identical maximum transmission power. Accordingly, the gain coefficient has a different value for each transmission mode, and therefore it is necessary to set the gain coefficient for the each transmission mode.

The above obtained post-peak suppression value is decided to be an initial value of the post-peak suppression value. Further, based on the obtained pre-peak suppression value, pre-peak suppression value table 41 is generated. The pre-peak suppression value related to the transmission power other than the reference transmission power is obtained according to the ratio to the reference transmission power, for each adjustment step width in coarse gain adjustment section 20.

As to the balance adjustment between a pre-peak suppression amount and a post-peak suppression amount, in order to secure high transmission quality, it is necessary to obtain by manual work of the operator. Therefore, as preparation processing, it is necessary to set the initial value of the post-peak suppression value, as a criterion, by obtaining the pre-peak suppression value and the post-peak suppression value for each transmission mode only to the reference transmission power. As to the power other than the reference transmission power, by means of the processing of the present embodiment, the gain coefficient and the post-peak suppression value are simultaneously modified after being obtained by calculation, according to the variation ratio of the transmission power. Thus, it is possible to set the pre-peak suppression value and the post-peak suppression value while maintaining the balance between the pre-peak suppression value and the post-peak suppression value.

The gain coefficient of coarse gain adjustment section 20 is set by the control from transmission power control section 5 (initiated by a set operation by the operator). The pre-peak suppression value is set to pre-peak suppression section 31, after CPU 43 in control section 4 selects from pre-peak suppression set table 41, based on the transmission power according to the gain coefficient of coarse gain adjustment section 20.

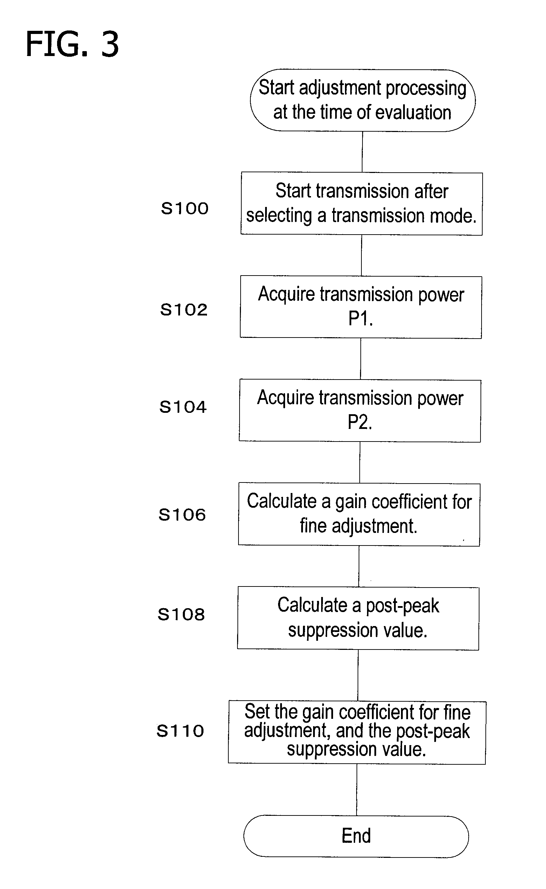

FIG. 3 is a processing flowchart of the gain coefficient adjustment processing in fine gain adjustment section 34 and the post-peak suppression value adjustment processing in post-peak suppression section 33 executed by the radio transmission apparatus having the first exemplary configuration. The present processing is to be processed after the above-mentioned preparation processing in the evaluation work before shipment from the factory.

The gain coefficient adjustment processing and the peak suppression value adjustment processing are carried out in the state that no DPD processing is performed. The processing is started after one transmission mode to be set is selected from among a plurality of transmission modes (types of transmission frequency bandwidth, for example, 10 MHz × 1 wave, 10 MHz × 2 waves, etc.) (S100), and a transmission signal is transmitted in the selected transmission mode.

When the transmission signal is transmitted from transmission signal generation section 1, CPU 43 acquires transmission power P1 of the transmission signal, which is output from coarse gain adjustment section 20 and measured by transmission power measurement section 10 (S102), and further, acquires transmission power P2 of the transmission signal which is output from amplifier 7 and measured by feedback power measurement section 11 (S104). The measured power is average power. Here, as to the transmission power P1 of the transmission signal being output from coarse gain adjustment section 20, a specified value given in advance from transmission power control section 5 may be used, in place of the power measured by transmission power measurement section 10.

Based on the variation ratio (P2/P1) between the both transmission power values P1, P2, CPU 43 calculates the gain coefficient of fine gain adjustment section 34 (S106). Specifically, let Gstd to be a gain coefficient being presently set in fine gain adjustment section 34, and Gchg to be a newly calculated gain coefficient, then, the gain coefficient Gchg is obtained from the following equation (1).

$$Gchg = (P2/P1) \times Gstd \quad \dots \quad (1)$$

The gain coefficient Gstd being presently set is a gain coefficient Gchg calculated in the gain adjustment processing performed in the previous time, and has an initial value "1" (at the time of the evaluation work before shipment from the factory, the above initial value "1" becomes Gstd).

Subsequently, CPU 43 calculates the post-peak suppression value (S108). Let Rstd to be a post-peak suppression value being presently set in post-peak suppression section 33 value, and Rchg to be a newly calculated post-peak suppression value, then, the post-peak suppression value Rchg is obtained from the following equation (2).

$$Rchg = (Gchg/Gstd) \times Rstd \quad ... \quad (2)$$

The post-peak suppression value Rstd being presently set is a post-peak suppression value Rchg calculated in the post-peak suppression value adjustment processing performed in the previous time. The initial value is a post-peak suppression value obtained correspondingly to the above-mentioned reference transmission power to the selected transmission mode. (At the time of the evaluation work before shipment from the factory, the above initial value becomes Rstd.)

In the above equation (2), the ratio of the gain coefficients (Gchg/Gstd) is used. Because (Gchg/Gstd)=(P2/P1) holds from equation (1), the post-peak suppression value is also proportional to the variation ratio of the transmission power.

CPU 43 sets the gain coefficient obtained in S106 to fine gain adjustment section 34, and also sets the post-peak suppression value obtained in S108 to post-peak suppression section 33 (S110).

In response to the variation of the transmission power, the post-peak suppression value being set in post-peak suppression section 33 is modified according to the variation ratio of the gain coefficient in fine gain adjustment section 34, without modifying the pre-peak suppression value. By this, it is possible to adjust the peak suppression value while maintaining CCDF to a constant, without limitation to the adjustment step width of the gain coefficient in principle (the fragmentation of the adjustment step width has limitation depending on the detection accuracy of the transmission power). Thus, in response to the variation of the transmission power, the peak suppression value can be adjusted at a smaller adjustment step width, without causing deterioration of the radio transmission characteristic such as EVM and ACLR. Moreover, it is not necessary to fit the adjustment step width in pre-peak suppression value set table 41 to a smaller adjustment step width in the post-peak suppression value. It is possible to leave a relatively coarse step width, as used in the conventional method. Further, a post-peak suppression value table becomes unnecessary.

Because fine gain adjustment section 34 obtains the gain coefficient by the calculation according to power difference, it becomes possible to set the gain coefficient in a smaller adjustment step width (with a step of 0.1 dB, for example). Further, since the peak suppression amount in the post-peak suppression section 33 by the window function method is approximately 1 dB in maximum, in case of adjustment up to ±0.5 dB, or of that order, with a step of 0.1 dB, it is easy to calculate the post-peak suppression value corresponding to the variation in the gain coefficient with a step of 0.1 dB. Thus, it is appropriate to process the gain adjustment using fine gain adjustment section 34 in combination with the post-peak suppression processing by post-peak suppression section 33. For the above reason, fine gain adjustment section 34 is disposed in a posterior stage to pre-peak suppression section 31 and also, in a prior stage to post-peak suppression section 33. Additionally, in regard to such a relatively large variation of the transmission power as exceeding 1 dB, the gain adjustment may be performed in coarse gain adjustment section 20. In response to the modification of the above gain coefficient, CPU 43 may modify and reset the peak suppression value to be set to pre-peak suppression section 31, based on pre-peak suppression set table 41.

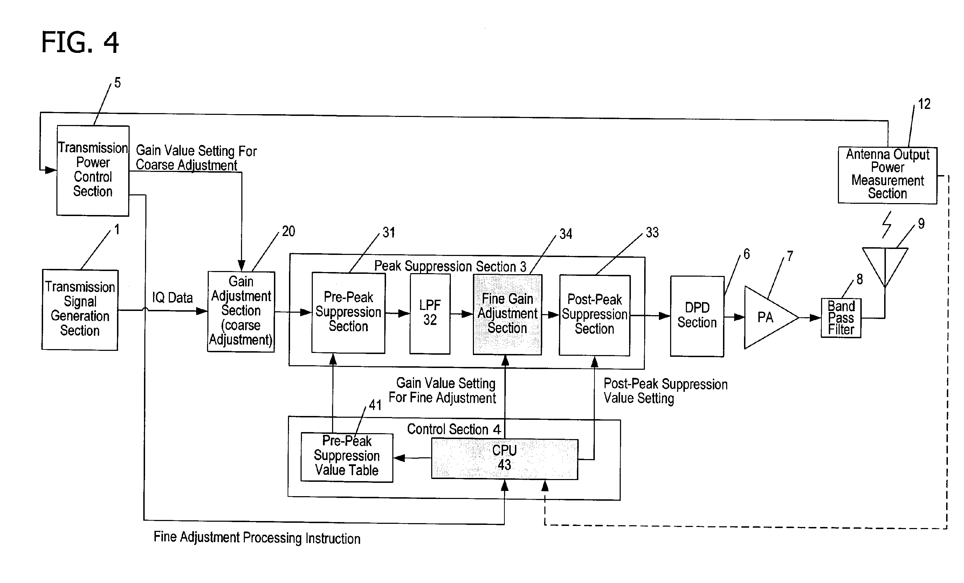

FIG. 4 is a diagram illustrating a second exemplary configuration of the radio transmission apparatus according to the present embodiment. In comparison with the first exemplary configuration shown in FIG. 2, the second exemplary configuration includes an antenna output power measurement unit 12 for directly measuring the transmission power of the transmission signal being output from antenna 9. Other configuration elements are similar to the elements in the first exemplary configuration.

The first exemplary configuration is a configuration for the gain adjustment processing and the peak suppression value adjustment processing executed at the time of evaluation work before shipment from the factory. On the other hand, the second exemplary configuration is a configuration for the gain adjustment processing and the peak suppression value adjustment processing, to be executed at a location in which the radio transmission apparatus is actually installed.

In the second exemplary configuration, because the transmission signal being output from antenna 9 is directly measured, it becomes possible to perform the peak suppression value adjustment, in response to the variation of the transmission power caused by the dispersion in a passing loss due to the difference in the cable length to antenna 9, and the dispersion in the passing loss of the entire components on the transmission signal path disposed at a posterior stage to amplifier 7, such as band pass filter 8.

Preferably, through the adjustment processing at the time of the evaluation work before shipment from the factory using the first exemplary configuration shown in FIG. 2, and also the adjustment processing at the installation location using the second exemplary configuration, it becomes possible to adjust the gain and the peak suppression value with higher accuracy.

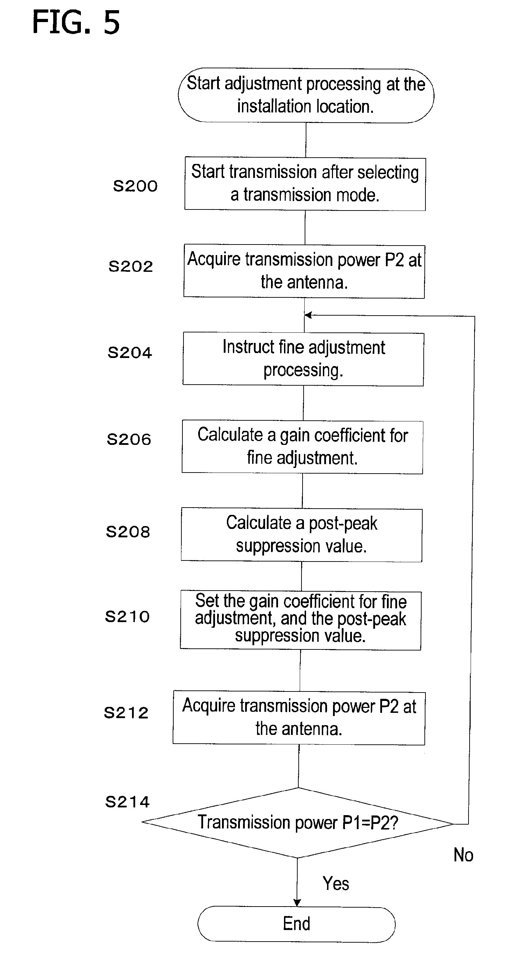

FIG. 5 is a processing flowchart of the gain coefficient adjustment processing in fine gain adjustment section 34 and the post-peak suppression value adjustment processing in post-peak suppression section 33, in the radio transmission apparatus having the second exemplary configuration.

The processing is started after one transmission mode to be set is selected from among a plurality of transmission modes (types of transmission frequency bandwidth, for example, 10 MHz $\times$ 1 wave, 10 MHz $\times$ 2 waves, etc.) (S200) and a transmission signal is transmitted in the selected transmission mode.

When the transmission signal is transmitted from transmission signal generation section 1, transmission power control section 5 acquires transmission power P2 measured by antenna output power measurement unit 12 (S202). Transmission power control section 5 then notifies CPU 43 of a specified value P1 of the transmission power from antenna 9 and the measured power P2, so as to instruct to execute fine adjustment processing (S204).

On the acquisition of the both transmission power values P1, P2, CPU 43 calculates the gain coefficient of fine gain adjustment section 34, based on the ratio (P2/P1) of the both transmission power values (S206). Specifically, a gain coefficient Gchg to be newly calculated is calculated from the above-mentioned equation (1). In equation (1), in case of processing for the first time at the installation location, the gain coefficient Gstd is Gchg having been obtained in the evaluation work performed before shipment from the factory, whose value is stored in the internal memorymeans of control section 4. The updated Gchg is stored in the internal memory means in an overwritten manner.

Subsequently, CPU 43 calculates a post-peak suppression value (S208). The newly calculated post-peak suppression value Rchg is obtained by the above equation (2). In equation (2), in the case of first time processing at the installation location, the presently set post-peak suppression value Rstd is Rchg which is obtained at the time of the evaluation work performed before shipment from the factory, whose value is stored in the internal memory means of control section 4. The updated Rchg is stored in the internal memory means in an overwritten manner.

CPU 43 sets the gain coefficient obtained in S206 to fine gain adjustment section 34, and also sets the post-peak suppression value obtained in S208 to post-peak suppression section 33 (S210).

Subsequently, in S210, after the gain coefficient and the post-peak suppression value are set, transmission power control section 5 acquires transmission power P2 measured by antenna output power measurement unit 12 (S212). It is decided whether or not the measured transmission power P2 is consistent with the specified value P1 of the transmission power (within a tolerable error) (S214), and in case of inconsistency, the processing of the above steps S204 through S212 is repeated. In case of consistency, the processing is completed.

By performing the processing shown in FIG. 3, which is executed at the time of the evaluation work before shipment from the factory, and the processing shown in FIG. 4 which is executed at the installation location, final adjustment of the gain and the post-peak suppression value is completed.

In the aforementioned processing, the transmission power measured by antenna output power measurement unit 12 is acquired by transmission power control section 5, and reported from transmission power control section 5 to CPU 43 in control section 4. However, it is also possible to configure to acquire directly by CPU 43 (dotted line in the figure). The specified value of the transmission power is also stored in advance in the internal memory means of control section 4. Further, with the provision of power measurement section 10 in the first configuration shown in FIG. 2, it may also be possible to use power (transmission signal power being output from coarse gain adjustment section 20) measured by power measurement section 10, in place of the specified value of the transmission power.

In the adjustment processing at the installation location also, the gain coefficient in fine gain adjustment section 34 is obtained by calculation in response to the variation of the transmission power, and further, according to the above gain coefficient, a post peak suppression value in post peak suppression section 33 can automatically be obtained by calculation, without deteriorating the radio transmission characteristic. Thus, the adjustment work at the installation location becomes easy and the adjustment time can greatly be reduced.

Further, because the peak suppression value can be adjusted flexibly to the dispersion of component characteristics, the use of an expensive component having small dispersion becomes unnecessary, which leads to the cost reduction of the radio transmission apparatus.

**Claims**

1. A radio transmission apparatus for generating a transmission signal including a peak component to transmit from an antenna, comprising:

   a first gain adjustment section for performing gain adjustment by multiplying the transmission signal by a first gain coefficient;
   a first peak suppression section for suppressing the peak component of the transmission signal being output from the first gain adjustment section, according to a first peak suppression value;
   a low pass filter for filtering the transmission signal being output from the first peak suppression section;
   a second gain adjustment section for performing gain adjustment by multiplying the transmission signal being output from the low pass filter by a second gain coefficient;
a second peak suppression section for suppressing the peak component of the transmission signal being output from the second gain adjustment section, according to a second peak suppression value; and
a control section for calculating the second gain coefficient and the second peak suppression value based on a variation ratio between transmission signal power being output from the first gain adjustment section and transmission signal power in a posterior stage to the second peak suppression section.

2. The radio transmission apparatus according to claim 1,

wherein the control section includes a table of the first peak suppression value to be set into the first peak suppression section for each of a plurality of transmission power values based on a unit of a first step, and wherein the control section is arranged to calculate the second gain coefficient and the second peak suppression value to the transmission power value based on a unit of a second step smaller than the first step, according to the variation ratio.

3. The radio transmission apparatus according to claim 1,
wherein the control section is arranged to multiply a present set value of the second gain coefficient and a present set value of the second peak suppression value by the variation ratio, so as to obtain a new set value of the second gain coefficient and a new set value of the second peak suppression value, to update the second gain coefficient being set to the second gain adjustment section from the present value thereof to the new value, and update the second peak suppression value being set to the peak suppression section from the present value to the new value.

4. The radio transmission apparatus according to claim 1, 2, or 3,

wherein the first peak suppression section is arranged to execute peak suppression processing by a hard clipping method, to cut a predetermined level or more of the transmission signal, and wherein the second peak suppression section is arranged to generate a predetermined window function, and to execute peak suppression processing by a window function method in which the window function value is multiplied by the transmission signal.

5. The radio transmission apparatus according to claim 1, 2, 3, or 4, further comprising:

an amplification section for amplifying a transmission signal being output from the second peak suppression section; and
a first power measurement section for measuring transmission signal power being output from the amplification section,
wherein the transmission signal power in a posterior stage to the second peak suppression section is power measured by the first power measurement section.

6. The radio transmission apparatus according to any preceding claim, further comprising:

a second power measurement section for measuring transmission signal power transmitted from the antenna, wherein the transmission signal power in a posterior stage to the second peak suppression section is power measured by the second power measurement section.

7. A method of generating a transmission signal including a peak component to be transmitted from an antenna, comprising:

performing first gain adjustment by multiplying the transmission signal by a first gain coefficient;
suppressing the peak component of the transmission signal being output from the first gain adjustment step, according to a first peak suppression value;
filtering the transmission signal resulting from the peak suppression step;
performing second gain adjustment by multiplying the transmission signal resulting from the low pass filtering step by a second gain coefficient;
a second peak suppression step of suppressing the peak component of the transmission signal following the second gain adjustment step, according to a second peak suppression value; and
calculating the second gain coefficient and the second peak suppression value based on a variation ratio between transmission signal power following the first gain adjustment step and transmission signal power at a stage prior to the second peak suppression step.

**8.** A program which, when executed by a processor of a radio communication apparatus, performs the method of claim 7.

**9.** A computer-readable medium on which is recorded the program of claim 8.

FIG. 1

FIG. 2

EP 2 124 347 A2

# FIG. 3

Start adjustment processing
at the time of evaluation

S100 — Start transmission after selecting a transmission mode.

S102 — Acquire transmission power P1.

S104 — Acquire transmission power P2.

S106 — Calculate a gain coefficient for fine adjustment.

S108 — Calculate a post-peak suppression value.

S110 — Set the gain coefficient for fine adjustment, and the post-peak suppression value.

End

# FIG. 4

EP 2 124 347 A2

# FIG. 5

```
┌──────────────────────────────────────┐
│ Start adjustment processing at the   │
│         installation location.       │
└──────────────────────────────────────┘
```

S200 — Start transmission after selecting a transmission mode.

S202 — Acquire transmission power P2 at the antenna.

S204 — Instruct fine adjustment processing.

S206 — Calculate a gain coefficient for fine adjustment.

S208 — Calculate a post-peak suppression value.

S210 — Set the gain coefficient for fine adjustment, and the post-peak suppression value.

S212 — Acquire transmission power P2 at the antenna.

S214 — Transmission power P1=P2?

No

Yes

End

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007194825 A